# FASCICULE DE BREVET EUROPEEN

(11) **EP 3 815 972 B1**
(45) Date de publication et mention de la délivrance du brevet: **02.08.2023**
(21) Numéro de dépôt: 20202403.0
(22) Date de dépôt: 16.10.2020
(51) Int. Cl.: B60Q 1/00, H05K 5/00

(54) **DISPOSITIF DE SUPPORT ET DE CONNEXION D'UNE CARTE ÉLECTRONIQUE POUR LE PILOTAGE D'UN MODULE D ÉCLAIRAGE OU DE SIGNALISATION DE VÉHICULE AUTOMOBILE**
TRÄGER- UND VREBINDUNGSVORRICHTUNG EINER ELEKTRONISCHEN KARTE FÜR DIE STEUERUNG EINES LICHT- ODER SIGNALISIERUNGSMODULS EINES KRAFTFAHRZEUGS
DEVICE FOR SUPPORTING AND CONNECTING AN ELECTRONIC CARD FOR CONTROLLING A LIGHTING OR SIGNALLING MODULE FOR A MOTOR VEHICLE

(30) Priorité: 29.10.2019 FR 1912108
(43) Date de publication de la demande: 05.05.2021
(73) Titulaire: PSA Automobiles SA, 78300 Poissy (FR)
(72) Inventeur: VIDEIRA, FILIPE, 78140 VELIZY VILLACOUBLAY (FR)

(56) Documents cités:
- EP-A1- 3 358 926
- EP-A2- 1 445 533

## Description

L'invention s'applique au domaine du pilotage électronique des modules d'éclairage et de signalisation des véhicules automobiles.

Plus précisément, l'invention concerne un dispositif assurant le support et la connexion amovibles de la carte électronique de pilotage à l'intérieur du boîtier d'un module d'éclairage ou de signalisation.

De manière traditionnelle, les véhicules automobiles sont équipés de modules d'éclairage (projecteurs, ...) et/ou de signalisation (feux arrière, feux de jour dits « DRL », ...). De tels modules comprennent, notamment, un boîtier destiné à contenir une ou plusieurs sources d'éclairage sous forme de lampes (halogènes, xénon, LED, ...) pilotées par une ou plusieurs cartes électroniques ou « driver » et associées à des systèmes optiques (lentille, réflecteur ...).

Lorsque la carte électronique est enfermée dans le boîtier, il est préférable pour effectuer des services de maintenance en après-vente que cette carte soit démontable, l'électronique de pilotage et de puissance pouvant présenter un taux de panne assez élevé. Dans ce cas, on procède à la découpe d'une partie de la paroi du boitier afin de pouvoir accéder à la carte en vue de son remplacement.

Toutefois, cette opération nécessite de disposer d'une longueur suffisante de câble électrique à l'intérieur du boîtier pour pouvoir aisément sortir la carte et avoir accès à la connectique. Or, cette longueur de câble est, d'une part, encombrante et peut, d'autre part, créer des problèmes d'interférence avec d'autres composants fonctionnels (optiques, mécaniques ou électroniques) logés également dans le boîtier.

Le brevet FR2867837B1 décrit un module de projecteur équipé d'une carte électronique et l'agencement de cette carte dans le boîtier du projecteur. Cet agencement consiste à utiliser un capot pour venir fermer un espace interne du boîtier dans lequel la carte électronique est disposée en formant ainsi un boîtier secondaire.

Les brevets FR2850729B1 et FR2843445B1 décrivent des modules de projecteur équipés de boîtiers extérieurs destinés à assurer la connexion avec des cartes électroniques.

On connaît par le document EP3358926 un dispositif de pilotage de l'alimentation électrique pour une source lumineuse à semi-conducteur.

De manière générale, ces documents antérieurs décrivent différents agencements de la carte électronique à l'intérieur ou à l'extérieur d'un boîtier de module d'éclairage. Cependant, ces agencements, lorsqu'ils sont prévus à l'intérieur du boîtier, ne permettent pas un montage et un démontage aisé de la carte à partir d'un support fixe de connexion.

En outre, ces documents, n'apportent pas non plus un quelconque moyen permettant de procéder à l'extraction de la carte électronique sans se soucier de la connectique.

Dans ce contexte, l'invention vise à apporter une solution technique permettant d'effectuer facilement la maintenance de la carte électronique en ouvrant le boîtier puis en la déconnectant des broches de son support fixe par simple traction.

Ce but est atteint au moyen d'un dispositif de support et de connexion d'une carte électronique de pilotage d'un module d'éclairage ou de signalisation, caractérisé en ce qu'il comprend un bâti intégrant, d'une part, un premier logement formé par deux rainures parallèles formant glissières destinées à recevoir les bords de ladite carte et, d'autre part, un second logement s'étendant perpendiculairement au premier logement et destiné à recevoir et retenir un connecteur électrique amovible venant en prise avec ladite carte dans l'interface entre les deux logements.

Selon une caractéristique avantageuse, le second logement est délimité, en partie basse, par un méplat couplé à un pivot de guidage et à une butée de calage et, en partie haute, par une patte flexible portant un ergot de verrouillage.

Selon une autre caractéristique, le premier logement est muni d'au moins une douille taraudée destinée à la réception d'une vis de fixation de la carte.

Selon une variante particulière, le bâti comprend une paroi médiane portant des nervures de calage contre lesquelles le connecteur vient en appui dans le second logement.

Selon encore une autre caractéristique, le méplat du second logement s'étend perpendiculairement à l'axe des rainures du premier logement et se prolonge par un coude portant le pivot de guidage à l'entrée du second logement.

Selon une variante de réalisation spécifique, la butée est positionnée au-dessus du niveau du pivot de guidage et est alignée avec l'extrémité du méplat formant le fond du second logement.

Selon une autre caractéristique de l'invention, il est prévu que la patte flexible délimite le second logement du côté opposé au méplat.

De préférence, ce méplat est porté par une paroi inférieure formant le fond du premier logement en partie basse.

Selon encore une autre variante, le bâti comprend une paroi supérieure disposée en regard de la patte flexible et délimitant le fond du premier logement en partie haute.

Un autre objet de l'invention est un module d'éclairage ou de signalisation pour véhicules automobiles comprenant un boîtier équipé d'un dispositif de support et de connexion d'une carte électronique de pilotage présentant les caractéristiques définies ci-dessus

L'invention s'applique de façon très générale au support et à la connexion de cartes électroniques amovibles logées dans un boîtier de module et destinées au pilotage de lampes à fonctions d'éclairage (projecteurs, ...) et/ou de signalisation (feux diurnes DRL, ...).

Grâce à l'invention, les logements assurant, respectivement, le support de la carte électronique amovible et le support du connecteur présentent une interface de connexion à l'intérieur d'un bâti commun lui-même intégré dans le boîtier du module.

Lors du démontage, il suffit alors d'accéder au bâti, de détacher les organes de fixation puis d'extraire la carte par traction sans se soucier de la connectique, ni du faisceau de câbles.

En outre, la longueur du faisceau de câble peut être raccourcie puisqu'il n'est plus nécessaire de l'étirer pour atteindre la carte électronique et l'extraire du boîtier ce qui permet de réaliser des modules plus légers et plus compacts.

D'autres caractéristiques et avantages de l'invention ressortiront à la lecture de la description qui va suivre, en référence aux figures annexées et détaillées ci-après.
[Fig. 1A] est une vue en perspective d'un mode de réalisation selon l'invention d'un dispositif de support et de connexion d'une carte électronique et d'un connecteur électrique, avant assemblage de la carte.
[Fig. 1B] est une vue en perspective du dispositif de support et de connexion de la figure 1A après mise en place de la carte électronique.
[Fig. 2A] est une vue partielle de face du dispositif de la figure 1A avec le connecteur et sans la carte électronique.
[Fig. 2B] est une vue partielle de derrière du dispositif de la figure 1A avec le connecteur et sans la carte électronique.
[Fig. 3A] est une vue de détail du dispositif de la figure 1A avec le connecteur en cours d'assemblage.
[Fig. 3B] est une vue de détail du dispositif de la figure 1A avec le connecteur en fin d'assemblage.
[Fig. 4] est une vue schématique de dessus et en en coupe selon le plan IV-IV (figure 2A) du logement destiné au connecteur électrique en position de verrouillage.

Pour plus de clarté, les éléments identiques ou similaires sont repérés par des signes de référence identiques sur l'ensemble des figures.

Naturellement, les modes de réalisation et de mise en oeuvre de l'invention illustrés par les figures présentées ci-dessus et décrites ci-après, ne sont donnés qu'à titre d'exemples non limitatifs. Il est explicitement prévu que l'on puisse proposer et combiner entre eux différents modes pour en proposer d'autres.

L'invention concerne le support et la connexion des cartes électroniques destinées au pilotage des modules d'éclairage et/ou de signalisation des véhicules automobiles.

Plus précisément, l'invention concerne un dispositif assurant l'intégration d'une carte électronique amovible et interchangeable et son raccordement à un connecteur électrique à l'intérieur d'un boîtier équipant ces modules d'éclairage et/ou de signalisation.

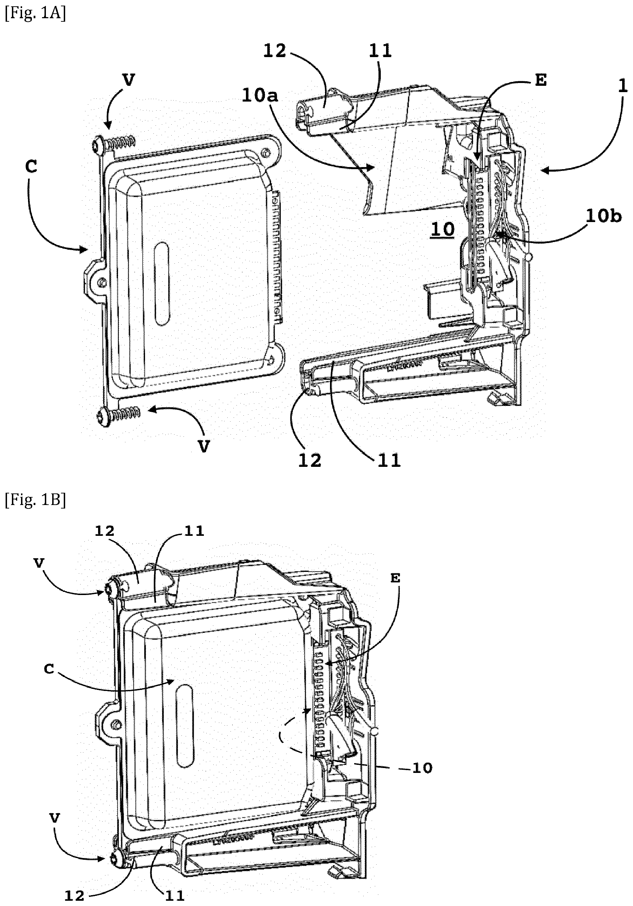

Les figures 1A et 1B représentent un mode de réalisation du dispositif de l'invention qui comprend un bâti 1 fixé à l'intérieur d'un boîtier (non représenté) et intégrant un premier logement 10a formé par deux rainures 11 parallèles formant glissières destinées à recevoir les bords d'une carte électronique C de façon coulissante.

Ce premier logement 10a est muni d'au moins une, et ici de deux douilles taraudées 12 portées par le bâti 1 et destinées à la réception d'organes assurant la fixation de la carte C tels que des vis V.

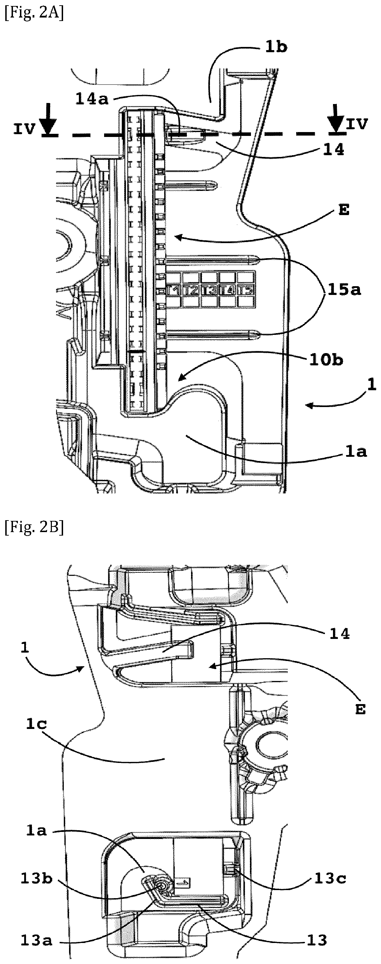

Comme illustré par les figures 2A et 2B, le bâti 1 comprend, en outre, un second logement 10b, s'étendant perpendiculairement au premier logement 10a, qui est destiné à recevoir un connecteur électrique E amovible avec lequel la carte C vient en prise, après serrage des vis V dans les douilles 12, au travers d'une ouverture centrale 10 formant l'interface entre les deux logements 10a, 10b,

A cet effet, la face avant du connecteur E orientée vers le premier logement 10a présente une série de broches assurant le raccordement électrique avec des contacts ménagés en vis-à-vis sur la carte C et orientés vers le second logement 10b.

Le connecteur E est raccordé par ailleurs à un faisceau de câbles (non représenté) et est susceptible d'être déplacé et extrait du second logement 10b par une cinématique de pivotement qui sera décrite en détail par la suite.

Le second logement 10b est délimité, en partie basse, par un méplat 13 porté par une paroi inférieure 1a du bâti 1 délimitant, vers l'arrière, le premier logement 10a. Le méplat 13 est couplé à un pivot 13b de guidage et à une butée 13c.

Le méplat 13 s'étend perpendiculairement à l'axe des rainures 11 du premier logement 10a et se prolonge par un coude 13a portant le pivot 13b de guidage à l'entrée du second logement 10b. La butée 13c est, quant à elle, positionnée au-dessus du niveau du pivot 13b et est alignée avec l'extrémité du méplat 13 en formant le fond du second logement 10b.

Le second logement 10b est délimité, en partie haute, par une patte flexible 14 portant un ergot 14a de verrouillage du connecteur E. Cette patte 14 est disposée du côté opposé au méplat 13 et donc ici sur la face arrière du bâti 1 (la face avant étant alors celle où se trouve le premier logement 10a).

Le bâti 1 comprend une paroi supérieure 1b disposée en regard de la patte flexible 14 et délimitant, en partie haute et vers l'avant, le second logement 10b du côté du méplat 13. La paroi 1b forme donc également, en partie haute, une partie du fond du premier logement 10a.

Le bâti 1 comprend, en outre, une paroi médiane 1c s'étendant sur sa face arrière et portant des nervures 15 de calage contre lesquelles le connecteur E vient en appui. La paroi 1c se prolonge jusqu'à la patte flexible 14 et délimite ainsi le second logement 10b vers l'arrière du bâti 1, comme illustré par les figures 2A et 2B.

L'ouverture centrale 10 située entre la paroi inférieure 1a et la paroi supérieure 1b forme l'interface de connexion de la carte C avec le connecteur E.

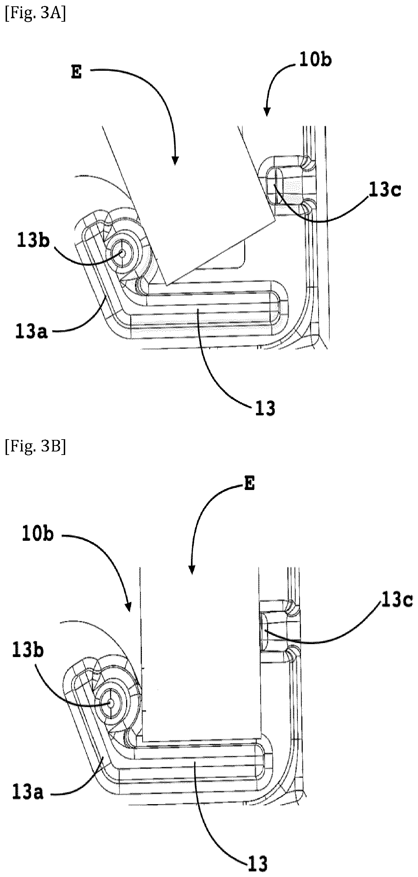

Le connecteur E peut être introduit dans le second logement 10b de la manière illustrée par les figures 3A et 3B et selon une cinématique consistant, d'abord, en une approche de direction rectiligne avec toutefois une inclinaison par rapport à sa position droite de verrouillage.

Une fois que son extrémité inférieure arrive en contact avec le méplat 13 et la butée 13c (figure 3A), le connecteur E est guidé en rotation autour du pivot 13b et se redresse.

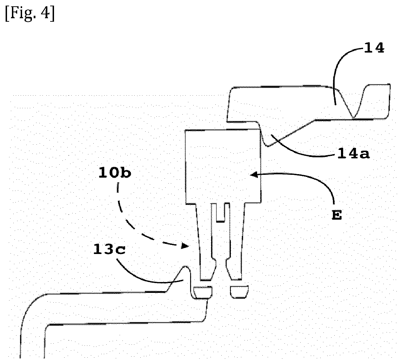

Conjointement, l'extrémité supérieure du connecteur E vient en appui contre l'ergot 14a en déformant élastiquement la patte flexible 14 située du côté opposé au méplat 13 dans le second logement 10b jusqu'à son verrouillage par encliquetage dans l'espace situé entre l'ergot 14a et la paroi formant le fond du second logement 10b, comme illustré par la figure 4.

Le connecteur E est ainsi retenu dans le second logement 10b par des appuis sur toute ses faces et est maintenu dans une position perpendiculaire à la carte C immobilisée dans le premier logement 10a par les rainures 11 et les vis ancrées dans les douilles 12.

Les opérations de démontage/remontage de la carte C peuvent être effectuées aisément sans se préoccuper des positions relatives de la carte C et du connecteur E et sans risquer d'endommager les faisceaux de câbles internes du projecteur.

L'accès au bâti 1, et donc à la carte électronique C et au connecteur E, peut être obtenu en découpant la paroi du boîtier dans la zone située en regard du bâti. En fin d'opération de maintenance, il sera alors possible de fixer un capot et un joint d'étanchéité sur le boîtier afin d'obturer la zone préalablement découpée.

Une autre solution consiste à prévoir une ouverture dans le boîtier dès sa fabrication et à l'obturer par un volet étanche et amovible.

## Revendications

1. Dispositif de support et de connexion d'une carte électronique (C) de pilotage d'un module d'éclairage ou de signalisation, comprenant un
bâti (1) intégrant, d'une part, un premier logement (10a) formé par deux rainures parallèles (11) formant glissières destinées à recevoir les bords de ladite carte et, d'autre part, un second logement (10b) s'étendant perpendiculairement au premier logement (10a) et destiné à recevoir et retenir un connecteur électrique (E) amovible venant en prise avec ladite carte (C) dans l'interface (10) entre les deux logements.

2. Dispositif selon la revendication 1, **caractérisé en ce que** le second logement (10b) est délimité, en partie basse, par un méplat (13) couplé à un pivot (13a) de guidage et à une butée (13c) et, en partie haute, par une patte flexible (14) portant un ergot (14a) de verrouillage.

3. Dispositif selon la revendication précédente, **caractérisé en ce que** ledit méplat (13) du second logement (10b) s'étend perpendiculairement à l'axe des rainures (11) du premier logement (10a) et se prolonge par un coude (13a) portant le pivot (13b) de guidage à l'entrée du second logement (10b).

4. Dispositif selon les revendications 2 et 3, **caractérisé en ce que** ladite butée (13c) est positionnée au-dessus du niveau du pivot (13b) de guidage et est alignée avec l'extrémité du méplat (13) formant le fond du second logement (10b).

5. Dispositif selon l'une des revendications 2 à 4, **caractérisé en ce que** la patte flexible (14) délimite le second logement (10b) du côté opposé au méplat (13).

6. Dispositif selon l'une des revendications 2 à 5, **caractérisé en ce que** le méplat (13) est porté par une paroi inférieure (1a) formant le fond du premier logement (10a) en partie basse.

7. Dispositif selon l'une des revendications 2 à 6, **caractérisé en ce que** ledit bâti (1) comprend une paroi supérieure (1b) disposée en regard de la patte flexible (14) et délimitant le fond du premier logement (10a) en partie haute.

8. Dispositif selon l'une des revendications précédentes, **caractérisé en ce que** ledit premier logement (10a) est muni d'au moins une douille (12) taraudée destinée à la réception d'une vis de fixation de la carte (C)

9. Dispositif selon l'une des revendications précédentes, **caractérisé en ce que** ledit bâti (1) comprend une paroi médiane (1c) portant des nervures (15) de calage contre lesquelles le connecteur (E) vient en appui dans le second logement (10b).

10. Module d'éclairage ou de signalisation pour véhicules automobiles comprenant un boîtier équipé d'un dispositif de support et de connexion d'une carte électronique (C) de pilotage selon l'une des revendications précédentes.

## Patentansprüche

1. Vorrichtung zum Tragen und Verbinden einer elektronischen Karte (C) zur Steuerung eines Beleuchtungs- oder Signalmoduls, mit einem Gestell (1), das einerseits eine erste Aufnahme (10a) integriert, die von zwei parallelen Nuten (11) gebildet wird, die Gleitschienen bilden, die dazu bestimmt sind, die Ränder der Karte aufzunehmen, und, andererseits eine zweite Aufnahme (10b), die sich senkrecht zur ersten Aufnahme (10a) erstreckt und dazu bestimmt ist, einen lösbaren elektrischen Verbinder (E) aufzunehmen und zu halten, der mit der Karte (C) in der Schnittstelle (10) zwischen den beiden Aufnahmen in Eingriff kommt.

2. Vorrichtung nach Anspruch 1, **dadurch gekennzeichnet, dass** die zweite Aufnahme (10b) im unteren Teil durch eine Abflachung (13), die mit einem Führungszapfen (13a) und einem Anschlag (13c) gekoppelt ist, und im oberen Teil durch eine flexible Lasche (14) begrenzt ist, die einen Verriegelungsnocken (14a) trägt.

3. Vorrichtung nach dem vorhergehenden Anspruch, **dadurch gekennzeichnet, dass** die Abflachung (13) der zweiten Aufnahme (10b) sich senkrecht zur Achse der Nuten (11) der ersten Aufnahme (10a) erstreckt und durch eine Biegung (13a) verlängert wird, die den Führungszapfen (13b) am Eingang der zweiten Aufnahme (10b) trägt.

4. Vorrichtung nach Anspruch 2 und 3, **dadurch gekennzeichnet, dass** der Anschlag (13c) oberhalb der Höhe des Führungszapfens (13b) positioniert ist und mit dem Ende der Abflachung (13), die den Boden der zweiten Aufnahme (10b) bildet, ausgerichtet ist.

5. Vorrichtung nach einem der Ansprüche 2 bis 4, **dadurch gekennzeichnet, dass** die flexible Lasche (14) die zweite Aufnahme (10b) auf der der Abflachung (13) gegenüberliegenden Seite begrenzt.

6. Vorrichtung nach einem der Ansprüche 2 bis 5, **dadurch gekennzeichnet, dass** die Abflachung (13) von einer unteren Wand (1a) getragen wird, die den Boden der ersten Aufnahme (10a) im unteren Bereich bildet.

7. Vorrichtung nach einem der Ansprüche 2 bis 6, **dadurch gekennzeichnet, dass** das Gestell (1) eine obere Wand (1b) umfasst, die gegenüber der flexiblen Lasche (14) angeordnet ist und den Boden der ersten Aufnahme (10a) im oberen Teil begrenzt.

8. Vorrichtung nach einem der vorhergehenden Ansprüche, **dadurch gekennzeichnet, dass** die erste Aufnahme (10a) mit mindestens einer Hülse (12) mit Innengewinde versehen ist, die zur Aufnahme einer Schraube zur Befestigung der Karte (C) bestimmt ist.

9. Vorrichtung nach einem der vorhergehenden Ansprüche, **dadurch gekennzeichnet, dass** das Gestell (1) eine Mittelwand (1c) umfasst, die Keilrippen (15) trägt, gegen die der Verbinder (E) in der zweiten Aufnahme (10b) zur Anlage kommt.

10. Beleuchtungs- oder Signalmodul für Kraftfahrzeuge mit einem Gehäuse, das mit einer Vorrichtung zur Halterung und zum Anschluss einer elektronischen Steuerkarte (C) nach einem der vorhergehenden Ansprüche ausgestattet ist.

## Claims

1. Device for supporting and connecting an electronic card (C) for controlling a lighting or signalling module, comprising a frame (1) incorporating, on the one hand, a first housing (10a) formed by two parallel grooves (11) forming slides intended to receive the edges of the said card and, on the other hand, a second housing (10b) extending perpendicularly to the first housing (10a) and intended to receive and hold a removable electrical connector (E) engaging with the said card (C), on the other hand, a second housing (10b) extending perpendicularly to the first housing (10a) and intended to receive and retain a removable electrical connector (E) engaging with the said card (C) in the interface (10) between the two housings.

2. Device according to claim 1, **characterised in that** the second housing (10b) is delimited, in the lower part, by a flat (13) coupled to a guide pivot (13a) and to a stop (13c) and, in the upper part, by a flexible lug (14) carrying a locking lug (14a).

3. Device according to the preceding claim, **characterised in that** the said flat (13) of the second housing (10b) extends perpendicularly to the axis of the grooves (11) of the first housing (10a) and is extended by a bend (13a) carrying the guide pivot (13b) at the entrance to the second housing (10b).

4. Device according to claims 2 and 3, **characterised in that** the said stop (13c) is positioned above the level of the guide pivot (13b) and is aligned with the end of the flat (13) forming the bottom of the second housing (10b).

5. Device according to one of claims 2 to 4, **characterised in that** the flexible lug (14) delimits the second housing (10b) on the side opposite the flat (13).

6. Device according to one of claims 2 to 5, **characterised in that** the flat (13) is carried by a lower wall (1a) forming the bottom of the first housing (10a) in the lower part.

7. Device according to one of claims 2 to 6, **characterized in that** the said frame (1) comprises an upper wall (1b) arranged opposite the flexible lug (14) and delimiting the bottom of the first housing (10a) in the upper part.

8. Device according to one of the preceding claims, **characterised in that** the said first housing (10a) is provided with at least one threaded bush (12) intended to receive a screw for fixing the card (C).

9. Device according to one of the preceding claims, **characterised in that** said frame (1) comprises a median wall (1c) carrying wedging ribs (15) against which the connector (E) bears in the second housing (10b).

10. Lighting or signalling module for motor vehicles comprising a housing equipped with a device for supporting and connecting an electronic control card (C) according to one of the preceding claims.
